(19) **Europäisches Patentamt**

**European Patent Office**

**Office européen des brevets**

(11) **EP 1 021 071 A1**

(12) **EUROPEAN PATENT APPLICATION**

(43) Date of publication:
**19.07.2000 Bulletin 2000/29**

(51) Int. Cl.[7]: **H05B 33/10, C23C 14/12**

(21) Application number: **00300198.9**

(22) Date of filing: **12.01.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **13.01.1999 JP 687599**

(71) Applicant: **TDK Corporation**
**Chuo-ku, Tokyo (JP)**

(72) Inventors:
• **Tanabe, Hiroshi,**
**TDK Corporation**
**Tokyo (JP)**

• **Tokura, Satoshi,**
**TDK Corporation**
**Tokyo (JP)**
• **Yamamoto, Hiroshi,**
**TDK Corporation**
**Tokyo (JP)**
• **Arai, Michio,**
**TDK Corporation**
**Tokyo (JP)**

(74) Representative:
**Sarup, David Alexander et al**
**Raworth, Moss & Cook,**
**Raworth House,**
**36 Sydenham Road**
**Croydon, Surrey CRO 2EF (GB)**

(54) **System and method for fabricating organic electroluminescent display devices**

(57)    The invention has for its object to provide an organic EL display fabrication system and method which can accommodate well to a substrate having a relatively large area as well as to various materials and evaporation conditions, and so can be used to fabricate an organic EL display device with high efficiency yet at low costs while film thickness variations are reduced with high efficiency in using materials and practically high film-formation rates. To achieve this, the invention provides a construction comprising a substrate 2 on which the organic EL display device is to be formed, a means for rotating the substrate and an evaporation source 4, wherein an n value is 3 to 18 as given by an approximate equation $m/m_0 = (L_0/L)^2 \cdot \cos^n \theta$ where $m_0$ is a vapor density at a center on an opening in the evaporation source 4 and at a distance $L_0$ from the opening and m is a vapor density at any position located at a radial angle $\theta$ from a center line of the opening and spaced away from the opening by a distance L. The evaporation source 4 is positioned with respect to the center C/L the substrate 2 such that the evaporation source is located at a position b that is 1.0 to 2.0 tines as long as a center-to-end distance a of the substrate. A vertical distance c from the opening in the evaporation source 4 to the substrate is 1.0 to 3.5 times as long as the center-to-end distance a of the substrate, and a center line of the evaporation source is at an angle $\theta_1$ of 1 to 45 degrees with respect to a perpendicular from a plane including a surface of the substrate down to the evaporation source.

**Description**

BACKGROUND OF THE INVENTION

Field of the Invention

The present invention relates generally to an organic EL (electroluminescent) device fabrication system, and more particularly to a system for fabricating an organic EL display device using an evaporation process wherein an organic source material for an organic EL device is evaporated by heating, so that the organic source material is deposited on a film-forming area on a substrate.

BACKGROUND ART

Among fundamental techniques for thin-film formation, there is a vacuum evaporation process wherein a thin film is formed using an appropriately combined evaporation source and film-forming substrate in a vacuum chamber. Various means for preparing the evaporation source are available to this end. For instance, a so-called resistance-heating evaporation process is known, wherein currents are passed through a metal vessel (metal boat) having a relatively high electric resistance, so that heat is generated to evaporate the starting material, as set forth in "Applied Physics Letter", Vol. 68, No. 16, 15 April 1996, pp. 2276-2278. There is also known a so-called electron beam • ion beam evaporation process wherein the starting material is directly irradiated with electron or laser beams, so that the starting material is evaporated by the resulting energy. Among these, the film-formation process (resistance-heating evaporation process) making use of resistance heating now finds wide applications because the film-formation system used is simple in structure and capable of forming a thin film of good quality at low costs.

According to the resistance-heating evaporation process, a high-melting metal material such as tungsten, tantalum and molybdenum is processed into a thin sheet having an increased electric resistance, from which a starting material container (metal boat) is in turn prepared. Then, a direct current is passed across the container to generate heat, which is used to evaporate the starting material, thereby providing a supply of evaporated gas. A part of the diffused gas is deposited on a substrate for thin-film formation. For the evaporation starting material used, any material having a relatively high vapor pressure may be used; however, materials susceptible to chemical reactions with the starting container must be avoided.

Such a resistance heating system causes less damage to organic layers, and so can be advantageously used as evaporation equipment for forming thin films constituting an organic EL device, for instance, organic films and cathodes. However, a substrate on which a thin film can be formed with such a vacuum evaporation system is limited to that having a relatively small size of the order of 100 x 100 mm, when it is intended to achieve uniform film thickness. Thus, when organic EL display devices are mass-fabricated by arranging organic EL devices on a matrix and making an appropriate selection from light-emitting elements to form characters, images or the like, thereby displaying thereon information, etc., the number of display devices that can be fabricated in one operation is limited with a fabrication efficiency drop. In addition, some limitation is imposed on the size of manufacturable screens, making the application of organic EL display devices to large screens difficult.

When no care is taken of any thickness variation, on the other hand, a film can be formed even on some large substrate. However, performance instability causes an increased percentage of rejects, and increased luminance and display variations in one display device. Thus, it is still difficult to achieve practically acceptable quality.

In consideration of practicability on an industrial level, a problem with the resistance heating system using a metal boat is that the amount of the material to be charged therein is limited.

In some cases, a cell type evaporation source, with which the amount of the material to be charged can be increased, may be used. To obtain a practicable film thickness distribution over a large area using this cell type evaporation source, however, it is required that while a substrate is rotated, the evaporation source be located on the outside of the radius of rotation of the substrate and the vertical distance from the evaporation source to the substrate be about twice as long as the center-to-end distance of the substrate, causing the efficiency of using material to drop considerably. In addition, it is impossible to increase the practical rotating rate of the substrate.

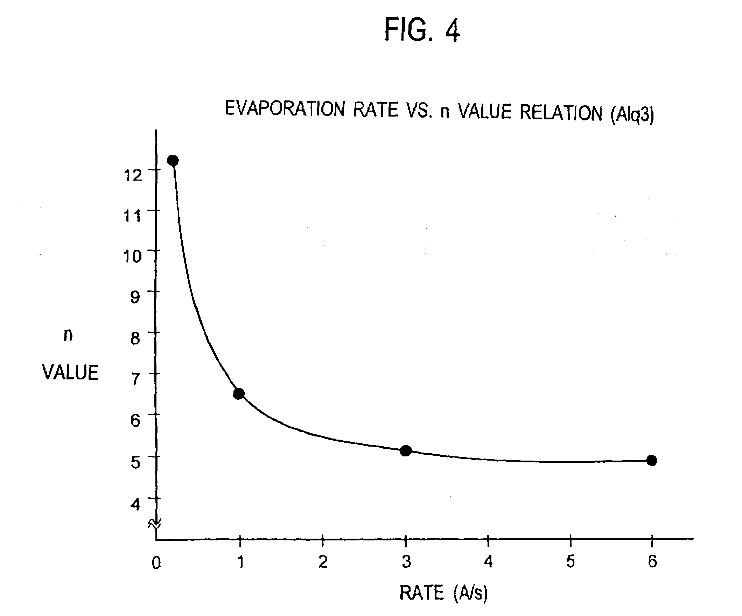

When the cell type evaporation source is used, it is difficult to accommodate to a variety of n values at the same cell location because the n value varies depending on material and evaporation rate. The n value may be controlled to a certain degree by controlling the orifice shape of the cell type evaporation source. Especially when a host material is evaporated with about 0.1% to 10% of a guest material mixed therewith, however, it is difficult to bring the n values of both close to each other depending on the orifice shape because, as can be seen from Fig. 4 for instance, there is a difference in the rate of deposition between the host material and the guest material.

It is therefore an object of the invention to provide an organic EL display fabrication system and method which can accommodate well to a substrate having a relatively large area as well as to various materials and evaporation conditions, and so can be used to fabricate an organic EL display device with high efficiency yet at low costs while film thickness variations are reduced with high efficiency in using materials and practically high film-formation rates.

SUMMARY OF THE INVENTION

The aforesaid object is achievable by the embodiments of the invention defined below as (1) to (4).

(1) An organic electroluminescent display device fabrication system comprising a substrate on which said organic EL display device is to be formed, a means for rotating said substrate and an evaporation source, wherein:

an n value is 3 to 18 as given by an approximate equation $m/m_0 = (L_0/L)^2 \cdot \cos^n \theta$ where $m_0$ is a vapor density at a center on an opening in said evaporation source and at a distance $L_0$ from said opening and m is a vapor density at any position located at a radial angle $\theta$ from a center line of said opening and spaced away from said opening by a distance L,
said evaporation source is positioned with respect to a center of said substrate such that said evaporation source is located at a position that is 1.0 to 2.0 times as long as a center-to-end distance of said substrate,
a vertical distance from said opening in said evaporation source to said substrate is 1.0 to 3.5 times as long as the center-to-end distance of said substrate, and
a center line of said evaporation source is at an angle of 1 to 45 degrees with respect to a perpendicular from a plane including a surface of said substrate down to said evaporation source.

(2) The fabrication system according to (1) above, wherein said substrate has a maximum length of 200 to 1,000 mm.
(3) The fabrication system according to (1) or (2) above, wherein an organic layer to be formed has a film-thickness distribution of ±10% or less.
(4) An organic electroluminescent display device fabrication method, wherein:

a substrate on which an organic electroluminescent display device is to be formed is located in a vacuum chamber,
an evaporation source is positioned with respect to a center of said substrate such that said evaporation source is located at a position that is 1.0 to 2.0 times as long as a center-to-end distance of said substrate while a vertical distance form an opening in said evaporation source to said substrate is 1.0 to 3.5 times as long as the center-to-end distance of said substrate,
an n value of said evaporation source is 3 to 18,
a center line of said evaporation source is at an angle of 1 to 45 degrees with respect to a perpendicular from a plane including a surface of said substrate down to said evaporation source, and
evaporation is effected while said substrate is rotated.

BRIEF DESCRIPTION OF THE DRAWINGS

FIG. 1 is a sectional view showing a half of one general construction of the system of the invention.
FIG. 2 is a plan view of FIG. 1.
FIG. 3 is a sectional view of part of a Knudsen cell used preferably with the system of the invention.
FIG. 4 is a graph showing an evaporation rate vs. n value relation (using $Alq^3$).

PREFERRED EMBODIMENTS OF THE INVENTION

According to the invention, there is provided an organic electroluminescent display device fabrication system comprising a substrate on which said organic EL display device is to be formed, a rotating means for rotating said substrate and an evaporation source, wherein:

an n value is 3 to 18 as given by an approximate equation $m/m_0 = (L_0/L)^2 \cdot \cos^n \theta$ where $m_0$ is a vapor density at a center on an opening in said evaporation source and at a distance $L_0$ from said opening and m is a vapor density at any position located at a radial angle $\theta$ from a center line of said opening and spaced away from said opening by a distance L,
said evaporation source is positioned with respect to the center of said substrate such that said evaporation source is located at a position that is 1.0 to 2.0 times as long as a center-to-end distance of said substrate,

a vertical distance from said opening in said evaporation source to said substrate is 1.0 to 3.5 times as long as the center-to-end distance of said substrate, and

a center line of said evaporation source is at an angle of 1 to 45 degrees with respect to a perpendicular from a plane including a surface of said substrate down to said evaporation source. By locating the evaporation source at a predetermined position where it is inclined with respect to the center of the substrate, it is thus possible to achieve a uniform film-thickness distribution corresponding to a wide range of n values over a substrate having a relatively large area, with high efficiency of using material and practical rates.

Requirements for the evaporation source are that (1) stable and precise temperature control is achievable, (2) the film deposition rate is so relatively fast that mass-fabrication is achievable, (3) the feed of the starting material enough for a large substrate can be ensured, (4) the evaporation source is less susceptible to chemical reactions with the constituents of an organic EL display device, and (5) the starting material can be easily diffused into a vapor state in a stable manner. No particular limitation is imposed on the evaporation source used herein with the proviso that it can meet such requirements; that is, various evaporation sources may be used. For such an evaporation source, it is preferable to use a Knudsen cell (hereinafter often called the K cell). The Knudsen cell is a cell having a given opening at a vapor jetting port. Given an opening diameter d and an opening thickness t as parameters, the distribution of vapor density on the jetting port is then obtained in a candle flame form or in an approximate form of $\cos^n \theta$. The n value is given by the approximate equation $m/m_0 = (L_0/L)^2 \cdot \cos^n \theta$, where m is a vapor density at any arbitrary position and $m_0$ is a vapor density at the center of the opening. The smaller d/t, the larger the n value is or the sharper the form of the flame is. In one extreme case where t = 0, n = 1 with a spherical distribution of vapor density on the opening. This is tantamount to evaporation from an open liquid surface, called Langmuir evaporation.

The n value changes with the material used, and varies depending on the rate of evaporation as well, as shown in Fig. 4. By control of d/t, etc., however, the n value may be regulated to a certain extent. In the invention, the n value should be in a predetermined range of from 3 to 18, preferably 3 to 15, and more preferably 3 to 12. This is because the vapor evaporating from the opening in the evaporation source, i.e., an orifice is variable with a variation in the n value. If the n value is within this range, then the system can work well. When the n value is smaller than the above lower limit, the spread of diffusion becomes too wide, resulting in a drop of film-formation efficiency. When the n value is greater than the above upper limit, the directivity of diffusion becomes too strong to accommodate to a large substrate.

The evaporation source is positioned with respect to the center of the substrate such that the evaporation source is located at a position that is 1.0 to 2.0 times, preferably 1.0 to 1.8 times and especially 1.1 to 1.6 times as long as the center-to-end distance of the substrate, and the vertical distance from the opening in the evaporation source to the substrate is 1.0 to 3.5 times, preferably 1.2 to 3.0 times and especially 1.4 to 2.5 times as long as the center-to-end distance of the substrate. The evaporation source is also inclined with respect to the substrate side such that the center line of the evaporation source passing vertically through the surface of the opening in the evaporation source is at an angle of 1 to 45 degrees, preferably 3 to 30 degrees and especially 5 to 20 degrees with respect to the perpendicular from a plane including the surface of the substrate down to the evaporation source. By locating the evaporation source at an inclined position which is spaced away from the center of the substrate by a given offset distance with respect to the n value in the predetermined range, it is thus possible to achieve a uniform film-thickness distribution, high efficiency of using material and a practical rate, thereby obtaining an organic EL display device having stabilized characteristics.

For evaporation, the substrate is rotated by the rotating means. It is then preferable that the evaporation source is inclined with respect to the center of rotation. Here given a circular cylinder crossing vertically the substrate surface and having a radius that is 0 to 0.5 times and preferably 0 to 0.2 times as long as the center-to-end distance of the substrate, it is then preferable that the center line of the evaporation source crosses the circular cylinder. Furthermore, it is preferable that the center line of the evaporation source crosses the center of rotation of the substrate.

The rotating means for rotating the substrate may be built up of a known rotating mechanism comprising a motor, a hydraulic rotating device or the like together with a reduction device comprising gears, belts, pulleys, etc. The substrate should preferably be rotated at about 1 to 50 rpm., and especially about 2 to 20 rpm.

By carrying out evaporation while the substrate is rotated, it is thus possible to achieve a uniform film-thickness distribution, high efficiency of using material and practical rates even when a large substrate is used.

By inclining the evaporation source, it is possible to achieve a satisfactory film-thickness distribution even over a short vertical distance. As already explained, the $m/m_0$ ratio may be given by the approximate equation

$$m/m_0 = (L_0/L)^2 \cdot (\cos \theta)^n$$

where $m_0$ is the vapor density at the center on the opening in the evaporation source and at the distance $L_0$ from the opening and m is the vapor density at any position located at the radial angle $\theta$ from the center line of the opening and spaced away from the opening by the distance L. A reduction in the vertical distance is tantamount to a reduction in the distance L. In other words, it is possible to increase the rate of deposition onto the substrate while the rate of evaporation from the evaporation source is kept constant. That the rate of deposition onto the substrate can be increased while the rate of evaporation from the evaporation source is kept constant is tantamount to that it is possible to increase the efficiency of using material that is the rate of the material deposited onto the substrate with respect to the material evaporated from the evaporation source.

As mentioned above, it is possible to achieve a satisfactory film-thickness distribution even with a shorter vertical distance. In other words, it is possible to reduce system size even when setting up a system compatible with a large-area substrate.

If the evaporation source positioned with respect to the center of the substrate such that the evaporation source is located at the position that is 1.0 to 2.0 times as long as the center-to-end distance of the substrate is inclined with respect to the center side of the substrate, it is also possible to make effective use of the aforesaid spread, so that while the rate of evaporation from the evaporation source is kept constant, the rate of deposition onto the substrate can be increased with an increase in the efficiency of using material.

Within the aforesaid range, a plurality of evaporation sources may be located concentrically with respect to the center of the substrate.

The film-thickness distribution of the thus formed thin film should be within preferably ±10%, preferably ±9%, and more preferably ±8%. A film-thickness distribution greater than ±10% causes the performance of an organic EL display device to become unstable.

Thin films formed for the constituents of an organic EL display device with the system according to the invention, for instance, include a hole injecting and transporting layer, a combined light emitting and electron injecting/transporting layer, an electron injecting electrode, and a protective layer. The materials used for these thin films may be metal, alloy and organic materials having the same composition as the thin films or capable of providing the same composition by evaporation.

For the electron injecting electrode material, it is preferable to use a substance having a low work function. For instance, use may be made of pure metal elements such as K, Li, Na, Mg, La, Ce, Ca, Sr, Ba, Al, Ag, In, Sn, Zn, and Zr, and a binary or ternary alloy system serving as a stabilizer and containing those elements. Exemplary alloys are Ag•Mg (Ag: 0.1 to 50 at%), Al•Li (Li: 0.01 to 14 at%, and especially 0.01 to 12 at%), In•Mg (Mg: 50 to 80 at%), and Al•Ca (Ca: 0.01 to 20 at%). For the electron injecting electrode layer, a thin film comprising one of these materials or a multilayer thin film comprising two or more of these material may be used.

For the protective layer, metal materials, inorganic material such as $SiO_x$, and organic materials such as Teflon may be used.

For the light emitting layer a fluorescent material that is a compound capable of emitting light is used. The fluorescent material used herein, for instance, may be at least one compound selected from compounds such as those disclosed in JP-A 63-264692, etc., quinacridone, rubrene, and styryl dyes. Use may also be made of quinoline derivatives such as metal complex dyes containing 8-quinolinol or its derivatives as ligands, for instance, tris (8-quinolinolato) aluminum, tetraphenylbutadiene, anthracene, perylene, coronene, and 12-phthaloperinone derivatives. Use may further be made of phenylanthracene derivatives disclosed in JP-A 8-12600 (Japanese Patent Application No. 6-110569) and tetraarylethene derivatives disclosed in JP-A 8-12969 (Japanese Patent Application No. 6-114456).

Preferably, the fluorescent compound is used in combination with a host substance capable of emitting light by itself; that is, it is preferable that the fluorescent compound is used as a dopant. In such a case, the content of the fluorescent compound in the light emitting layer is in the range of preferably 0.01 to 10 % by weight, and especially 0.1 to 5% by weight. By using the fluorescent compound in combination with the host substance, it is possible to vary the wavelength performance of light emission of the host substance, thereby making light emission possible on a longer wavelength side and, hence, improving the light emission efficiency and stability of the device.

Quinolinolato complexes, and aluminum complexes containing 8-quinolinol or its derivatives as ligands are preferred for the host substance. Such aluminum complexes are typically disclosed in JP-A's 63-264692, 3-255190, 5-70773, 5-258859, 6-215874, etc.

Exemplary aluminum complexes include tris(8-quinolinolato) aluminum; bis(8-quinolinolato) magnesium, bis(benzo{f}-8-quinolinolato) zinc, bis(2-methyl-8-quinolinolato)aluminum oxide, tris(8-quinolinolato)indium, tris(5-methyl-8-quinolinolato)aluminum, 8-quinolinolato-lithium, tris (5-chloro-8-quinolinolato)gallium, bis (5-chloro-8-quinolinolato)calcium, 5,7-dichloro-8-quinolinolato-aluminum, tris(5,7-dibromo-8-hydroxyquinolinolato)aluminum, and poly[zinc(II)-bis(8-hydroxy-5-quinolinyl)methane].

Use may also be made of aluminum complexes containing other ligands in addition to 8-quinolinol or its derivatives, for instance, bis(2-methyl-8-quinolinolato)(phenolato) aluminum (III), bis(2-methyl-8-quinolinolato)(o-cresolato) aluminum (III), bis(2-methyl-8-quinolinolato)(m-cresolato) aluminum (III), bis(2-methyl-8-quinolinolato)(p-cresolato) aluminum (III), bis(2-methyl-8-quinolinolato)(o-phenylphenolato)aluminum (III), bis(2-methyl-8-quinolinolato)(m-phenylphenolato)aluminum (III), bis(2-methyl-8-quinolinolato)(p-phenylphenolato)aluminum (III), bis(2-methyl-8-quinolinolato)(2,3-dimethylphenolato)aluminum (III), bis(2-methyl-8-quinolinolato)(2,6-dimethylphenolato) aluminum (III), bis(2-methyl-8-quinolinolato)(3,4-dimethylphenolato) aluminum (III), bis(2-methyl-8-quinolinolato)(3,5-dimethylphenolato)aluminum (III), bis(2-methyl-8-quinolinolato)(3,5-di-tert-butylphenolato)aluminum (III), bis(2-methyl-8-quinolinolato)(2,6-diphenylphenolato)aluminum (III), bis(2-methyl-8-quinolinolato)(2,4,6-triphenyl-phenolato)aluminum (III), bis(2-methyl-8-quinolinolato) (2,3,6-trimethylphenolato) aluminum (III), bis(2-methyl-8-quinolinolato)(2,3,5,6-tetramethylphenolato)aluminum (III), bis(2-methyl-8-quinolinolato)(1-naptholato)aluminum (III), bis(2-methyl-8-quinolinolato)(2-naptholato)aluminum (III), bis(2,4-dimethyl-8-quinolinolato)(o-phenylphenolato)aluminum (III), bis(2,4-dimethyl-8-quinolinolato)(p-phenylphenolato) aluminum (III), bis(2,4-dimethyl-8-quinolinolato)(m-phenylphenolato)aluminum (III), bis(2,4-dimethyl-8-quinolinolato) (3,5-dimethylphenolato)aluminum (III), bis(2,4-dimethyl-8-quinolinolato)(3,5-di-tert-butylphenolato)aluminum (III), bis(2-methyl-4-ethyl-8-quinolinolato)(p-cresolato)aluminum (III), bis(2-methyl-4-methoxy-8-quinolinolato)(p-phenylphenolato)aluminum (III), bis(2-methyl-5-cyano-8-quinolinolato)(o-cresolato)aluminum (III), and bis(2-methyl-6-trifluoromethyl-8-quinolinolato)(2-naptholato)aluminum (III).

Besides, use may be made of bis(2-methyl-8-quinolinolato)aluminum (III)-µ-oxo-bis(2-methyl-8-quinolinolato) aluminum (III), bis(2,4-dimethyl-8-quinolinolato)aluminum (III)-µ-oxo-bis(2,4-dimethyl-8-quinolinolato)aluminum (III), bis(4-ethyl-2-methyl-8-quinolinolato)aluminum (III)-µ-oxo-bis(4-ethyl-8-quinolinolato)aluminum (III), bis(2-methyl-4-methoxyquinolinolato)aluminum (III)-µ-oxo-bis(2-methyl-4-methoxyquinolinolato)aluminum (III), bis(5-cyano-2-methyl-8-quinolinolato)aluminum (III)-µ-oxo-bis(5-cyano-2-methyl-8-quinolinolato)aluminum (III), bis(2-methyl-5-trifluoromethyl-8-quinolinolato)aluminum (III)-µ-oxo-bis(2-methyl-5-trifluoromethyl-8-quinolinolato)aluminum (III), etc.

Other preferable host substances include phenylanthracene derivatives disclosed in JP-A 8-12600, tetraarylethene derivatives disclosed in JP-A 8-12969, etc.

In the invention, the light emitting layer may also serve as an electron injecting and transporting layer. In this case, it is preferable to use a fluorescent material, e.g., tris(8-quinolinolato)aluminum or the like.

For the compounds capable of injecting and transporting electrons, it is preferable to use metal complexes containing quinoline derivatives, especially 8-quinolinol or its derivatives as ligands, in particular, tris(8-quinolinolato) aluminum ($Alq^3$). It is also preferable to use the aforesaid phenylanthracene derivatives, and tetraarylethene derivatives.

For the compounds for the injection and transportation of holes, it is preferable to use amine derivatives having strong fluorescence, for instance, triphenyldiamine derivatives, styrylamine derivatives, and amine derivatives having an aromatic fused ring.

The pressure for evaporation should preferably be $1 \times 10^{-8}$ to $1 \times 10^{-5}$ Torr and the evaporation source should preferably be heated to a temperature of about 100 to 1,400°C for metal materials and to a temperature of about 100 to 500°C for organic materials.

The substrate is not critical to the practice of the invention provided that thin films for constituting an organic EL display device can be laminated thereon. The substrate, when it is located on the side out of which light is taken, may be formed of a transparent or semi-transparent material, for instance, glass, quartz, and resin. The substrate may further be used in combination with a color filter film, fluorescent material-containing color conversion film or dielectric reflecting film for controlling the color of light emission. The substrate, when it is located on the side out of which the emitted light is not taken, way be either transparent or opaque. Ceramics, etc. may be used for an opaque substrate.

The size of the substrate, too, is not critical to the practice of the invention. However, the substrate should preferably have a maximum length, esp., a diagonal length of 200 to 1,000 mm, and especially 400 to 700 mm. Although no problem arises at a maximum length of less than 200 mm, a substrate having a maximum length of 200 mm or greater is preferable because a uniform film-thickness distribution is achievable. A substrate of greater than 1,000 mm in size is not preferable because a film-formation system becomes large, resulting in a drop of film-formation efficiency and making film thickness control difficult.

A more illustrative construction of the fabrication system according to the invention will now be explained with reference to the drawings.

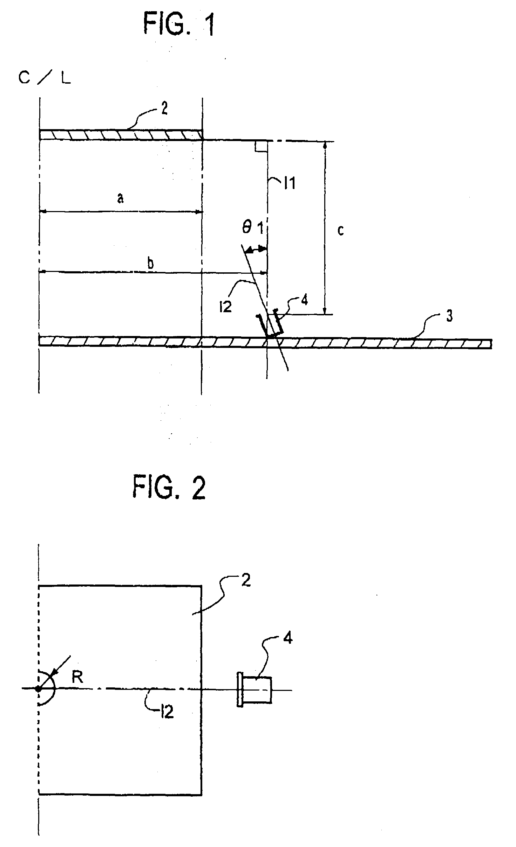

Fig. 1 is a sectional view illustrating a half of the basic construction of the present system. As illustrated, the organic EL display device fabrication system of the invention comprises a substrate 2, a table 3 with an evaporation source placed thereon and an evaporation source 4. Illustrated in Fig. 1 is a right half of the fabrication system with respect to the center L/C of the substrate 2. Thus, the evaporation source 4 is located at a position between the center-to-end distance a of the substrate and a distance b that is twice as long as the distance a, with a vertical distance c from an opening 24 in the evaporation source 4 to the substrate 2 being 1.0 to 3.5 times as long as the center-to-end distance of the substrate 2. It is here noted that the position of the evaporation source 4 is defined by the center position of the opening in the evaporation source 4.

The evaporation source 4 is also inclined with respect to the side of the substrate 2 such that a center line 12 of the evaporation source 4 passing vertically through the surface of the opening is at an angle $\theta 1$ of 1 to 45 degrees, preferably 3 to 30 degrees and especially 5 to 20 degrees with respect to a perpendicular 11 from a plane including the substrate surface down to the evaporation source 4.

Fig. 2 is a plan view of the Fig. 1 system as viewed from above (from the substrate side). Here given a circular cylinder crossing vertically the substrate surface and having a radius R that is 0 to 0.5 times and preferably 0 to 0.2 times as long as the center-to-end distance of the substrate, it is then preferable that the center line 12 of the evaporation source 4 crosses the circular cylinder. More preferably, the center line 12 of the evaporation source 4 crosses the center of rotation of the substrate.

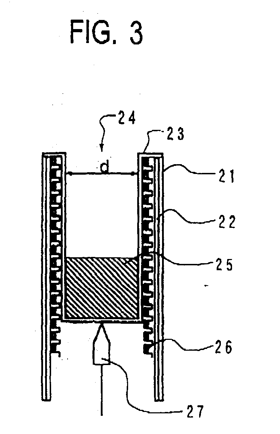

Fig. 3 is a sectional view of part of a more specific embodiment of the evaporation source 4 preferably used in the invention. As illustrated, the evaporation source 4 comprises an outer case 21, a heat insulator 22, a crucible 23, an opening 24, a material 25, a heating means 26 and a temperature sensor means 27.

The crucible 23 should preferably be made up of a material less susceptible to chemical reaction with the material 25 to be evaporated and capable of standing up to a given temperature, for instance, ceramics such as pyrolytic boron nitride (PBN) and alumina, and quartz, with PBN being particularly preferred. Preferably but not exclusively, the outer case 21 should be made up of a material having given strength, corrosion resistance, etc. For instance, an appropriate selection may be made from the following materials for the heat insulator 22. Alternatively, the outer case 21 may be formed of the heat insulator 22. The heat insulator 22 may be made up of a material having heat reflection, heat resistance, corrosion resistance, etc., for instance, molybdenum, tantalum, stainless steel (SUS 316), Inconel, cow wool, and asbestos.

For the heating means 26, use may be made of any desired device having given heat capacity, reactivity, etc., for instance, a tantalum wire heater and a sheath heater. By the heating means 26, the evaporation source should preferably be heated to a temperature of about 100 to 1,400°C, and precision of temperature control should be typically about ±1°C and preferably about ± 0.5°C at 1,000°C, although varying depending on the material to be evaporated. The temperature sensor means 27 may be a sensor capable of providing correct detection of the temperature of the material 25 in the crucible 23, which sensor may be made up of a thermocouple such as a platinum/platinum-rhodium, and tungsten/tungsten-rhenium.

EXAMPLES

The present invention will now be explained more specifically with reference to examples.

Example 1

A substrate of 200 mm x 200 mm in size was provided in a vacuum chamber. While an evaporation source was moved 140 to 300 mm away from the center of the substrate, evaporation was carried out at varied positions to measure the film-thickness distributions of the thus deposited films. At this time, while the substrate was horizontally rotated around its center, the center axis of the evaporation source was directed to the axis of rotation of the substrate and inclined at an angle of 15 degrees with respect to the perpendicular from the substrate plane down to the evaporation source in the direction of the axis of rotation of the substrate. The n value was fixed at any one of 3, 6, 9, 12, 15 and 18 and Alq[3] was used for the material to be evaporated. The vertical distance from the substrate to the opening in the evaporation source was 300 mm. Assuming that the rate of deposition at a position just 500 mm above the evaporation source was 1 at the respective positions and n values, the rates of deposition of the material deposited directly onto the substrate were relatively measured and compared. The film-deposition conditions are shown in Table 1, and the obtained results are reported in Table 2. Intended by the "optimum radius position" used herein is a value found by moving the cell from the center of rotation of the substrate to a certain radius to measure a film-thickness distribution and determining a radius at which the film-thickness distribution is minimized. At this optimum radius the film-thickness distribution is less susceptible to variations even when the n value varies.

When the evaporation source was located at a position 220 mm away from the center of the substrate, film-thickness distributions of ±10% or less were achieved all over the n value range of 3 to 18. The then relative rates of deposition were from 1:35 (n = 3) to 0.53 (n = 18) via 0.88 (n = 9).

Example 2

Films were prepared following Example 1 with the exception that the substrate had a size of 370 mm x 470 mm, the movement range for the evaporation source was from 280 mm to 400 mm as measured from the center of the substrate and the vertical distance from the substrate to the opening in the evaporation source was 500 mm. Then, the film-thickness distributions and the relative rates of deposition were measured as in Example 1. The film-formation conditions are shown in Table 1, and the obtained results are reported in Table 2.

When the evaporation source was located at a position 400 mm away from the center of the substrate, film-thickness distributions of ±10% or less were achieved all over the n value range of 3 to 12. At this time, the relative rates of deposition were from 0.45 (n = 3) to 0.23 (n = 12) via 0.35 (n = 6) to 0.28 (n = 9).

Example 3

Films were prepared following Example 2 with the exception that the vertical distance from the substrate to the opening in the evaporation source was 600 mm and the inclination of the evaporation source was 10 degrees. Then, the film-thickness distributions and the relative rates of deposition were measured as in Example 2. The film-formation conditions are shown in Table 1, and the obtained results are reported in Table 2.
When the evaporation source was located at a position 380 mm away from the center of the substrate, film-thickness distributions of ±10% or less were achieved all over the n value range of 3 to 15. At this time, the relative rates of deposition were from 0.37 (n = 3) to 0.17 (n = 15) via 0.24 (n = 9) to 0.20 (n = 12).

Example 4

Films were prepared following Example 1 with the exception that the substrate had a size of 550 mm x 650 mm, the movement range for the evaporation source was from 400 mm to 500 mm as measured from the center of the substrate, the vertical distance from the substrate to the opening in the evaporation source was 700 mm and the inclination of the evaporation source was 10 degrees. Then, the film-thickness distributions and the relative rates of deposition were measured as in Example 1. The film-formation conditions are shown in Table 1, and the obtained results are reported in Table 2.
When the evaporation source was located at a position 500 mm away from the center of the substrate, film-thickness distributions of ±10% or less were achieved all over the n value range of 3 to 12. At this time, the relative rates of deposition were from 0.24 (n = 3) to 0.11 (n = 12) via 0.18 (n = 6).

Comparative Example 1

Films were prepared following Example 1 with the exception that the inclination of the evaporation source was 0 degree. Then, the film-thickness distributions and the relative rates of deposition were measured as in Example 1. The film-formation conditions are shown in Table 1, and the obtained results are reported in Table 2.
The n value range where film-thickness distributions of ±10% or less were achievable was narrower than could be obtained in Example 1. When the evaporation source was located at a position 160 mm away from the center of the substrate, the n value range where film-thickness distributions of ±10% or less were achievable was as narrow as 3 to 9. The then relative rates of deposition, although varying with the n value, were 1.35 (n = 3) to 0.39 (n = 18) via 0.73 (n = 9). As compared with the relative rates of deposition obtained in Example 1, those at n = 9 and n = 18 were considerably low.

Comparative Example 2

Films were prepared following Example 1 with the exception that the inclination of the evaporation source was 0 degree and the vertical distance from the substrate to the opening in the evaporation source was 400 mm. Then, the film-thickness distributions and the relative rates of deposition were measured as in Example 1. The film-formation conditions are shown in Table 1, and the obtained results are reported in Table 2.
When the evaporation source was located at a position 160 mm away from the center of the substrate, film-thickness distributions of ±10% or less were achieved all over the n value range of 3 to 18. At this time, however, the relative rates of deposition were from 0.98 (n = 3) to 0.38 (n = 18) via 0.63 (n = 9); that is, they were only about 71 to 73% of those obtained in Example 1.

Comparative Example 3

Films were prepared following Example 2 with the exception that the inclination of the evaporation source was 0 degree. Then, the film-thickness distributions and the relative rates of deposition were measured as in Example 2. The film-formation conditions are shown in Table 1, and the obtained results are reported in Table 2.
The n value range where film-thickness distributions of ±10% or less were achievable was narrower than could be obtained in Example 2. When the evaporation source was located at a position 300 to 340 mm away from the center of the substrate, the n value range where film-thickness distributions of ±10% or less were achievable was as narrow as 3 to 6. The then relative rates of deposition were highest when the evaporation source was located at 300 mm, and were 0.44 (n = 3) to 0.16 (n = 12) via 0.30 (n = 6), although varying with the n value. As compared with the relative rates of deposition obtained in Example 2, those at n = 6 to 12 in particular were remarkably low.

Comparative Example 4

Films were prepared following Example 3 with the exception that the inclination of the evaporation source was 0 degree. Then, the film-thickness distributions and the relative rates of deposition were measured as in Example 3. The film-formation conditions are shown in Table 1, and the obtained results are reported in Table 2.

The n value range where film-thickness distributions of ±10% or less were achievable was narrower than could be obtained in Example 3. When the evaporation source was located at a position 300 mm away from the center of the substrate, the n value range where film-thickness distributions of ±10% or less were achievable was as narrow as 3 to 12. The then relative rates of deposition, although varying with the n value, were 0.37 (n = 3) to 0.13 (n = 15) via 0.21 (n = 9) to 0.16 (n = 12); that is, they were only 70 to 82% of those obtained in Example 3. As compared with the relative rates of deposition obtained in Example 3, those on an n value higher side of n = 9-15 were noticeably low.

Comparative Example 5

Films were prepared following Example 4 with the exception that the inclination of the evaporation source was 0 degree. Then, the film-thickness distributions and the relative rates of deposition were measured as in Example 4. The film-formation conditions are shown in Table 1, and the obtained results are reported in Table 2.

The n value range where film-thickness distributions of ±10% or less were achievable was narrower than could be obtained in Example 4. When the evaporation source was located at a position 420 to 480 mm away from the center of the substrate, the n value range where film-thickness distributions of ±10% or less were achievable was as narrow as 3 to 6. The then relative rates of deposition were highest when the evaporation source was located at 420 mm, and were 0.23 (n = 3) to 0.08 (n = 12) via 0.15 (n = 6), although varying with the n value. As compared with the relative rates of deposition obtained in Example 4, those at n = 6 to 12 in particular were remarkably low.

Table 1

| | Film-formation conditions for substrate | | | | Film-formation conditions for the Location of Evaporation Source | |
| --- | --- | --- | --- | --- | --- | --- |
| | Short-side length (mm) | Long-side length (mm) | Diagonal length (mm) | Inclination (deg) | Vertical distance (mm) | Optimum radius position (mm) |
| Ex. 1 | 200 | 200 | 283 | 15 | 300 | 220 |
| Ex. 2 | 370 | 470 | 598 | 15 | 500 | 400 |
| Ex. 3 | 370 | 470 | 598 | 10 | 600 | 380 |
| Ex. 4 | 550 | 650 | 851 | 10 | 700 | 500 |
| Com. Ex. 1 | 200 | 200 | 283 | 0 | 300 | 160 |
| Com. Ex. 2 | 200 | 200 | 283 | 0 | 400 | 160 |
| Com. Ex. 3 | 370 | 470 | 598 | 0 | 500 | 300 |
| Com. Ex. 4 | 370 | 470 | 598 | 0 | 600 | 300 |
| Com. Ex. 5 | 550 | 650 | 851 | 0 | 700 | 420 |

Table 2

| Results of film formation n vale | | | | | | | | | | | | |
|---|---|---|---|---|---|---|---|---|---|---|---|---|
| | 3 | | 6 | | 9 | | 12 | | 15 | | 18 | |
| | TD* ±% | ROD** | TD* ±% | ROD** | TD* ±% | ROD** | TD* ±% | ROD** | TD* ±% | ROD** | TD* ±% | ROD** |
| Ex. 1 | 6.6 | 1.35 | 7.9 | 1.08 | 7.2 | 0.88 | 6.1 | 0.73 | 5.3 | 0.62 | 9.3 | 0.53 |
| Ex. 2 | 7.3 | 0.45 | 7.9 | 0.35 | 7.2 | 0.28 | 6.7 | 0.23 | 12.0 | 0.19 | 19.3 | 0.16 |
| Ex. 3 | 8.5 | 0.37 | 9.6 | 0.30 | 8.3 | 0.24 | 7.0 | 0.20 | 6.7 | 0.17 | 12.4 | 0.14 |
| Ex. 4 | 8.9 | 0.24 | 8.5 | 0.18 | 7.4 | 0.14 | 9.9 | 0.11 | 18.1 | 0.09 | 27.5 | 0.08 |
| Comp. Ex. 1 | 8.2 | 1.35 | 5.1 | 0.96 | 5.7 | 0.73 | 15.1 | 0.57 | 26.6 | 0.46 | 38.6 | 0.39 |
| Comp. Ex. 2 | 8.3 | 0.98 | 9.5 | 0.77 | 8.2 | 0.63 | 5.3 | 0.52 | 3.3 | 0.44 | 7.8 | 0.38 |
| Comp. Ex. 3 | 8.4 | 0.44 | 4.7 | 0.30 | 13.4 | 0.22 | 27.2 | 0.16 | 41.8 | 0.13 | 55.6 | 0.10 |
| Comp. Ex. 4 | 9.9 | 0.37 | 8.1 | 0.27 | 5.0 | 0.21 | 9.9 | 0.16 | 19.4 | 0.13 | 30.0 | 0.11 |
| Comp. Ex. 5 | 8.8 | 0.23 | 5.1 | 0.15 | 13.4 | 0.11 | 27.1 | 0.08 | 41.9 | 0.07 | 55.5 | 0.05 |

TD* Thickness Distribution
ROD** Rate of Deposition

ADVANTAGES OF THE INVENTION

According to the invention as explained above, it is possible to provide an organic EL display fabrication system and method which can accommodate well to a substrate having a relatively large area as well as to various materials and evaporation conditions, and so can be used to fabricate an organic EL display device with high efficiency yet at low costs while film thickness variations are reduced with high efficiency in using materials and practically high film-formation rates.

Japanese Patent Application No. 11-6875 is herein incorporated by reference.

While the invention has been described in detail and with reference to specific embodiments thereof, it will be apparent to one skilled in the art that various changes and modifications may be made therein without departing from the spirit and scope thereof.

**Claims**

1. An organic electroluminescent display device fabrication system comprising a substrate on which said organic EL display device is to be formed, a means for rotating said substrate and an evaporation source, wherein:

an n value is 3 to 18 as given by an approximate equation $m/m_0 = (L_0/L)^2 \cdot \cos^n \theta$ where $m_0$ is a vapor density at a center on an opening in said evaporation source and at a distance $L_0$ from said opening and m is a vapor density at any position located at a radial angle $\theta$ from a center line of said opening and spaced away from said opening by a distance L,
said evaporation source is positioned with respect to a center of said substrate such that said evaporation source is located at a position that is 1.0 to 2.0 times as long as a center-to-end distance of said substrate,
a vertical distance from said opening in said evaporation source to said substrate is 1.0 to 3.5 times as long as the center-to-end distance of said substrate, and
a center line of said evaporation source is at an angle of 1 to 45 degrees with respect to a perpendicular from a plane including a surface of said substrate down to said evaporation source.

**2.** The fabrication system according to claim 1, wherein said substrate has a maximum length of 200 to 1,000 mm.

**3.** The fabrication system according to claim 1 or 2 above, wherein an organic layer to be formed has a film-thickness distribution of ±10% or less.

**4.** An organic electroluminescent display device fabrication method, wherein:

a substrate on which an organic electroluminescent display device is to be formed is located in a vacuum chamber,

an evaporation source is positioned with respect to a center of said substrate such that said evaporation source is located at a position that is 1.0 to 2.0 times as long as a center-to-end distance of said substrate while a vertical distance form art opening in said evaporation source to said substrate is 1.0 to 3.5 times as long as the center-to-end distance of said substrate,

an n value of said evaporation source is 3 to 18,

a center line of said evaporation source is at an angle of 1 to 45 degrees with respect to a perpendicular from a plane including a surface of said substrate down to said evaporation source, and

evaporation is effected while said substrate is rotated.

# FIG. 1

C / L

a

b

2

θ1

l1

l2

c

4

3

# FIG. 2

2

R

l2

4

# FIG. 3

# FIG. 4

EVAPORATION RATE VS. n VALUE RELATION (Alq3)

**European Patent Office**

## EUROPEAN SEARCH REPORT

Application Number

EP 00 30 0198

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A,P | EP 0 926 927 A (TDK CORP) 30 June 1999 (1999-06-30) * the whole document * | 1-4 | H05B33/10 C23C14/12 |
| A | PATENT ABSTRACTS OF JAPAN vol. 1999, no. 03, 31 March 1999 (1999-03-31) & JP 10 335062 A (TDK CORP), 18 December 1998 (1998-12-18) * abstract * | 1-4 | |
| A | PATENT ABSTRACTS OF JAPAN vol. 1999, no. 03, 31 March 1999 (1999-03-31) & JP 10 330917 A (ULVAC JAPAN LTD), 15 December 1998 (1998-12-15) * abstract * | 1-4 | |

TECHNICAL FIELDS SEARCHED (Int.Cl.7)

H05B
C23C

The present search report has been drawn up for all claims

| Place of search | Date of completion of the search | Examiner |
|---|---|---|
| THE HAGUE | 10 April 2000 | Drouot, M-C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 00 30 0198

This annex lists the patent family members relating to the patent documents cited in the above-mentioned European search report.
The members are as contained in the European Patent Office EDP file on
The European Patent Office is in no way liable for these particulars which are merely given for the purpose of information.

10-04-2000

| Patent document cited in search report | | Publication date | Patent family member(s) | | Publication date |
|---|---|---|---|---|---|
| EP 0926927 | A | 30-06-1999 | JP 11195485 | A | 21-07-1999 |
| JP 10335062 | A | 18-12-1998 | NONE | | |
| JP 10330917 | A | 15-12-1998 | NONE | | |

EPO FORM P0459

For more details about this annex : see Official Journal of the European Patent Office, No. 12/82